# EUROPÄISCHE PATENTSCHRIFT

(11) **EP 1 566 463 B1**
(45) Veröffentlichungstag und Bekanntmachung des Hinweises auf die Patenterteilung: **16.07.2008**
(21) Anmeldenummer: 04003600.6
(22) Anmeldetag: 18.02.2004
(51) Int. Cl.: C23C 14/06

(54) **Verschleissschutzschicht für ein formgebendes Werkzeug**
Anti-abrasion coating for tools
Dépot anti-abrasif pour outils

(43) Veröffentlichungstag der Anmeldung: 24.08.2005
(73) Patentinhaber: Jürgen Bach Immobilien und Maschinen KG, 90425 Nürnberg (DE)
(72) Erfinder:
(74) Vertreter: Schneck, Herbert

(56) Entgegenhaltungen:
- EP-A- 0 872 575
- EP-A- 1 132 498
- EP-A- 1 354 984
- LEMBKE M I ET AL: "Significance of Y and Cr in TiAlN hard coatings for dry high speed cutting" SURF ENG; SURFACE ENGINEERING 2001, Bd. 17, Nr. 2, 2001, Seiten 153-158, XP002286335
- LEWIS D B ET AL: "The influence of the yttrium content on the structure and properties of Ti1-x-y-zAlxCryYzN PVD hard coatings" SURFACE AND COATINGS TECHNOLOGY, ELSEVIER, AMSTERDAM, NL, Bd. 114, Nr. 2-3, 12. Mai 1999 (1999-05-12), Seiten 187-199, XP002243759 ISSN: 0257-8972
- VETTER J ET AL: "AlTiCrNO coatings for dry cutting deposited by reactive cathodic vacuum arc evaporation" SURF. COAT. TECHNOL. (SWITZERLAND), SURFACE & COATINGS TECHNOLOGY, SEPT.-OCT. 2003, ELSEVIER, SWITZERLAND, Bd. 174-175, 9. September 2002 (2002-09-09), Seiten 615-619, XP002286336 ISSN: 0257-8972

## Beschreibung

Die Erfindung betrifft eine Verschleißschutzschicht für ein formgebendes Werkzeug.

Im Bereich der formgebenden, also insbesondere der umformenden oder der spanabhebenden (= zerspanenden) Bearbeitung von Werkstoffen werden Werkzeuge beispielsweise in Gestalt eines Schaftfräsers aus einem Stahl oder einem Hartmetall (zum Beispiel ein Metall aus WC/Co) oder einer Wendeschneidplatte aus einem Hartmetall eingesetzt. Sowohl bei der Trocken- als auch bei der Nassbearbeitung von Werkstoffen gibt es Anwendungen mit hohen Anforderungen an die Qualität und die Leistungsfähigkeit der eingesetzten Werkzeuge. Gerade auch hinsichtlich der Standfestigkeit bestehen hohe Forderungen.

Zum Schutz und auch zur Qualitätsverbesserung werden die Werkzeuge deshalb mit einer harten keramischen Verschleißschutzschicht versehen. Insbesondere bei Werkzeugen mit hoher geforderter Warmfestigkeit und Oxidationsbeständigkeit sind Verschleißschutzschichten bekannt, die aus Materialien auf der Basis von Titanaluminiumnitrid (TiAl)N bestehen. Diese Metallnitride dienen manchmal auch nur als Grundsubstanz, der verschiedene metallische und/oder nichtmetallische Zusatzelemente beispielsweise zur Kornverfeinerung oder zur Veränderung einer anderen Eigenschaft zugesetzt werden.

Trotz vieler Ansätze zur Optimierung der Eigenschaften weisen derzeit gängige Verschleißschutzschichten immer noch keine befriedigende Standfestigkeit auf. Sie eignen sich deshalb auch nur bedingt für einen Einsatz zur trockenen, d.h. zu einer ohne Kühlschmierstoff erfolgenden, zerspanenden Bearbeitung harter Werkstoffe.

In dem Fachaufsatz von Lembke M. et al. "Significance of Y and Cr in Ti-AlN hard coatings for dry high speed cutting", Surface Engineering, Volume 17, No. 2, 2001, Seiten 153 bis 158 werden teils mehrschichtige Verschleißschutzschichten für formgebende Werkzeuge beschrieben. Sie bestehen aus einem Material mit einem Metall-Materialanteil und einem Nichtmetall-Materialanteil. Der Metall-Materialanteil umfasst bei einer Zwischenschicht einen Chrom-Anteil, einen Titan-Anteil, einen Yttrium-Anteil und einen Aluminium-Anteil. Der Nichtmetall-Materialanteil umfasst bei dieser Zwischenschicht Stickstoff und einen im Grenzbereich zur Oberfläche hin zunehmenden Sauerstoff-Anteil.

Die Aufgabe der Erfindung besteht nun darin, eine Verschleißschutzschicht der eingangs bezeichneten Art anzugeben, die verglichen mit bekannten Lösungen eine verbesserte Standfestigkeit aufweist.

Zur Lösung dieser Aufgabe wird eine Verschleißschutzschicht entsprechend den Merkmalen des Patentanspruchs 1 angegeben.

Die Erfindung beruht dabei auf der Erkenntnis, dass eine Verschleißschutzschicht aus einem Material mit den beanspruchten metallischen und nichtmetallischen Materialkomponenten und -zusammensetzungen gerade auch bei einem Einsatz zur Trockenzerspanung von harten Werkstoffen, die beispielsweise eine Rockwell-Härte (HRC) von mindestens 35 haben können, überaus beständig ist und demzufolge eine lange Verwendbarkeit des so beschichteten Werkzeugs ermöglicht. Insbesondere wurde erkannt, dass der Titan-Anteil im Metall-Materialanteil 29 % nicht überschreiten sollte. Bei Werten von über 30% sinkt die Oxidationsbeständigkeit, wodurch sich ein Absinken der Verschleißbeständigkeit beim Trockenzerspanen harter Werkstoffe, beispielsweise gehärteter Stähle, ergibt.

Eine Erhöhung des auf die gesamten Metall-Atomprozente, also auf den gesamten Metall-Materialanteil bezogenen Chrom-Anteils, der vorzugsweise zwischen 1 und 60 % liegt, führt insbesondere bei der Trockenbearbeitung von Werkzeugstählen mit einer Rockwell-Härte von unter 50 zu Standzeitvorteilen.

Günstig wirkt sich außerdem auch der beanspruchte Yttrium-Anteil im Metall-Materialanteil aus. Yttrium führt zu einer Strukturverbesserung, insbesondere zu einer Kornverfeinerung und damit zu einer sehr vorteilhaften Verschleißbeständigkeit. Verbessert wird auch die thermische Beständigkeit und die erzielbare Härte. Besonders vorteilhafte diesbezügliche Materialeigenschaften ergeben sich insbesondere bei einen Yttrium-Anteil von 0,5 bis 4 %.

Der Einbau von Sauerstoff mit einem Anteil von 1 bis 10 % des Nichtmetall-Materialanteils erhöht einerseits die Oxidationsbeständigkeit und trägt andererseits zur Verbesserung der Warmfestigkeit bei.

Außer den genannten und in Anspruch 1 angegebenen Material-Komponenten kann die Verschleißschutzschicht auch noch weitere Material-Komponenten, wie beispielsweise Kohlenstoff (C) oder/und Bor (B), in geringen Mengen beinhalten.

Vorteilhafte Ausgestaltungen der erfindungsgemäßen Verschleißschutzschicht ergeben sich aus den von Anspruch 1 abhängigen Ansprüchen.

Die Ausgestaltung nach Anspruch 2 mit einem Aluminium-Anteil zwischen 40 und 85 % zeichnet sich durch Standzeitvorteile aus. Diese sind besonders ausgeprägt, wenn eine hochaluminiumhaltige Verschleißschicht verwendet wird. Insbesondere beträgt der Aluminium-Anteil zwischen 50 und 80 %, vorzugsweise mindestens 70 %. Sehr hoch ist die Standfestigkeit insbesondere dann, wenn außerdem ein geringer Chrom-Anteil von etwa zwischen 1 bis 20 % vorgesehen ist. Die genannten Prozentangaben beziehen sich jeweils auf die Metall-Atomprozente, also auf den Metall-Materialanteil.

Bevorzugte Ausführungsbeispiele werden nunmehr anhand der Zeichnung erläutert. Zur Verdeutlichung ist die Zeichnung nicht maßstäblich ausgeführt und gewisse Aspekte sind nur schematisiert dargestellt. Im Einzelnen zeigen:
- Fig. 1: eine Anlage zur Erzeugung einer Verschleißschutzschicht,
- Fig. 2: gemessene Verläufe der verschiedenen Materialanteile der Verschleißschutzschicht und
- Fig. 3: einen Standzeit-Vergleich herkömmlicher Verschleißschutzschichten mit einer erfindungsgemäßen Verschleißschutzschicht.

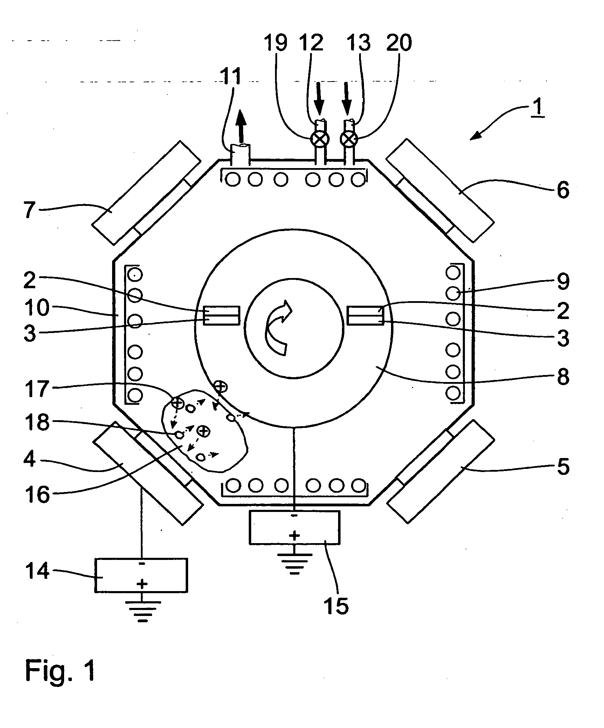

In Fig. 1 ist eine Anlage 1 zur Erzeugung einer insbesondere keramischen Verschleißschutzschicht 2 auf einem Werkzeug 3 nach dem SputterVerfahren dargestellt. Alternativ könnte jedoch ebenso ein anderes geeignetes Verfahren, zum Beispiel ein PVD (Physical Vapour Deposition)-Arc-Verfahren eingesetzt werden. Die so hergestellte Verschleißschutzschicht 3 kann vorzugsweise keramischen, aber auch metallischen Charakter haben. Die Anlage 1 hat ein Mehrkathodensystem mit im Beispiel von Fig. 1 gezeigten vier Kathoden 4, 5, 6 und 7, die auch als Target bezeichnet werden. Außerdem ermöglicht ein drehbarer Substrattisch 8, auf dem das zu beschichtende Werkzeug 3, insbesondere um mindestens eine weitere Drehachse drehbar platziert ist, während des Beschichtungs-Vorgangs eine Rotation. Die mögliche Drehbewegung des Substrattisches 8 ist in Fig. 1 durch den Pfeil angedeutet.

Der Substrattisch 8 befindet sich in einem mittels Heizelementen 9 heizbaren und als Vakuumkammer ausgebildeten Rezipienten 10, an dem mehrere Anschlüsse 11, 12 und 13 vorgesehen sind. Der Anschluss 11 führt zu einer in Fig. 1 nicht gezeigten Vakuumpumpe. Die beiden Anschlüsse 12 und 13 dienen der Zuführung von Prozessgasen, beispielsweise eines Inertgases wie Argon (Ar) und von Reaktivgasen wie Stickstoff (N₂) oder Sauerstoff (O₂).

Mittels Spannungsquellen 14 und 15 können an die Kathoden 4, 5, 6 und 7 ebenso wie an den Substrattisch 8 vorgebbare Potentialwerte angelegt werden. Beispielhaft ist in Fig. 1 nur für die Kathode 4 ein solcher Anschluss an die Spannungsquelle 14 gezeigt. Der Substrattisch 8 und auch die Kathode 4 sind negativ vorgespannt, wobei die Vorspannung an der Kathode 4 beispielsweise 200 bis 400 V und die am Substrattisch 8 beispielsweise einige 10 bis 200 V beträgt.

Die Beschichtung erfolgt, indem zunächst beispielsweise mittels Zündung ein Plasma 16 mit positiven Inertgas-Ionen 17 gebildet wird. Aufgrund der hohen negativen Vorspannung der Kathode 4 werden die Inertgas-Ionen 17 in Richtung Kathode 4 beschleunigt. Beim Aufprall werden Sekundäratome 18 aus der Kathode 4 herausgeschlagen. Die Sekundäratome 18 bewegen sich als zerstäubte Target-Teilchen regellos und scheiden sich auf gegenüberliegenden Flächen, insbesondere auf dem Werkstück 3 ab.

Die negative Vorspannung des Substrattischs 8 und damit auch der darauf platzierten zu beschichtenden Werkstücke 3 dient zur Vermeidung von Verunreinigung. Die Verschleißschutzschicht 2 wird dann während des Wachstums ständig mit Inertgas-Ionen 17 bombardiert und damit von unerwünschten Adsorbaten gereinigt.

Die Kathoden 4, 5, 6 und 7 können unterschiedliche Material-Zusammensetzungen aufweisen. Sie können beispielsweise aus Metallverbindungen (AlTi, AlCr, AlTiCrY) oder auch aus den Basismetallen (Al, Ti, Cr, Y) bestehen. Durch Veränderung der Material-Zusammensetzungen der Kathoden 4, 5, 6 und 7 lässt sich die Material-Zusammensetzung der aufwachsenden Verschleißschutzschicht 2 in weiten Grenzen variieren.

Nichtmetallische Materialanteile der Verschleißschutzschicht 2 werden je nach gewünschter Material-Zusammensetzung insbesondere auch in Gasform zugeführt. Hier ist eine Variation sehr leicht über eine Kontrolle der zugeführten Gasmenge und -art möglich. Die Steuerung des Gaszuflusses erfolgt mittels in den Anschlüssen 12 und 13 vorgesehener Ventile 19 bzw. 20.

Mittels der Anlage 1 kann auch der strukturelle Aufbau der aufwachsenden Verschleißschutzschicht 2 beeinflusst und eingestellt werden. Insbesondere lässt sich eine monolagige, eine multilagige und eine nanokristalline Struktur erzeugen. Als Maßnahmen hierzu stehen beispielsweise eine Variation der effektiven Beschichtungszeit, eine Variation der Kathodenleistung, also der Verdampfungs- oder der Sputterrate, oder eine Variation der Drehgeschwindigkeit des Substrattischs 8 zur Verfügung. Die Beschichtungszeit bezüglich einer oder mehrerer der Kathoden 4, 5, 6 und 7 lässt sich zum Beispiel durch den Einsatz von in Fig. 1 nicht explizit gezeigten Shuttem steuern.

Die Anlage 1 eignet sich also zur Herstellung verschiedener Verschleißschutzschichten 2, die sich sowohl in der Material-Zusammensetzung als auch im strukturellen Aufbau unterscheiden können. Insbesondere ist ein ein- oder ein mehrlagiger Schichtaufbau möglich. Die bevorzugte Gesamtdicke der Verschleißschutzschichten 2 bewegt sich in einem Bereich zwischen 0,5 und 12 µm. Herstellen lassen sich bereits bekannte Verschleißschutzschichten 2 aus Titannitrid (TiN), Chromnitrid (CrN), Titancarbonitrid (TiCN) und Titanaluminiumnitrid (TiAlN), aber insbesondere auch Verschleißschutzschichten 2 mit Aluminium (Al), Titan (Ti), Chrom (Cr) und Yttrium (Y) als Metallkomponenten sowie mit Sauerstoff (O) und Stickstoff (N) als Nichtmetallkomponenten (AlTiCrY(O,N)). Die Metalle Aluminium, Titan, Chrom und Yttrium liegen bei der Verschleißschutzschicht 2 aus AlTiCrY(O,N) insbesondere in chemischer Bindung als Oxynitride vor.

Eine Untersuchung der verschiedenen Verschleißschutzschichten 2 liefert ihre jeweiligen Eigenschaften, insbesondere die Material-Zusammensetzung, den strukturellen Aufbau, die Härte und die Standzeit.

Zur chemischen Bestimmung der Material-Zusammensetzung kann ein EDX (Energy Dispersive X-ray)-, GDOS (Glow Discharge Optical Spectroscopy)- oder ein SIMS (Secondary Ion Mass Spectrometry)-Verfahren eingesetzt werden. Die Charakterisierung des strukturellen Aufbaus kann mittels einer metallografischen Untersuchung oder einer Raster-Elektronenmikroskopie (REM) erfolgen. Zur Bestimmung der Härte und auch der Elastizität eignet sich beispielsweise eine Kleinstlast-Universalhärteprüfung.

Die Standzeit lässt sich insbesondere mittels eines Praxistests ermitteln. So kann beispielsweise ein mit einer Verschleißschutzschicht 2 versehenes Werkzeug 3 in Form eines Vollhartmetall-Schlichtfräsers oder eines Vollhartmetall-Radienfräsers einem ungekühlten, also trockenen Fräsversuch in Gestalt einer Zerspanung eines gehärteten Werkzeugstahls mit einer Rockwell-Härte zwischen 35 und 67 HRC unterzogen werden. Beispielsweise kann der Trockenzerspanungs-Test an einem Werkzeugstahl 1.2379 (X155CrVMo12.1) in auf 62 HRC gehärtetem Zustand durchgeführt werden. Die danach feststellbaren Kriterien Verschleißfortschritt und Verschleißerscheinungsbild dienen als Maß für die Standzeit.

Hinsichtlich der vorstehenden Eigenschaften ist eine Verschleißschutzschicht 2 aus AlTiCrY(O,N) mit folgender Material-Zusammensetzung:

(Al_{1-x-y-z}CrₓTi_{y}Y_{z}) (OₙN₁₋ₙ)

mit
0,01 ≤ x ≤ 0,6
0,01 ≤ y ≤ 0,29
0 < z ≤ 0,05
0,01 ≤ n ≤ 0,1
sehr vorteilhaft. Als besonders bevorzugt haben sich dabei die folgenden Unterbereiche herausgestellt:
0,01 ≤ x ≤ 0,4
0,02 ≤ y ≤ 0,25
0,005 ≤ z ≤ 0,04
0,01 ≤ n ≤ 0,08.

Die vorstehenden Angaben gelten sowohl für einen einlagigen Aufbau mit einer im Wesentlichen homogenen Mischphase als auch für einen mehrlagigen Aufbau mit mehreren Einzellagen. Die Einzellagen können sich in ihrer jeweiligen Material-Zusammensetzung gleichen oder auch voneinander unterscheiden. Eine besonders harte und zähe Verschleißschutzschicht 2 erhält man mittels einer sogenannten nanostrukturierten Multilagenbeschichtung, bei der sehr feine Einzellagen mit Lagendicken zwischen 3 und 50 nm, vorzugsweise zwischen 3 und 20 nm vorgesehen sind. Aufgrund der geringen Lagendicke stellen sich vorteilhafte mechanische Spannungen zwischen den Einzellagen, die auch als Nanolagen bezeichnet werden, ein. Selbst bei aufgrund der Material-Zusammensetzung eigentlich nur zähen Einzellagen ergibt sich dank dieser mechanischen Spannungen für die Verschleißschutzschicht 2 insgesamt eine sehr hohe Härte. Weiterhin können in den Einzellagen wechselnde Anteile von Metall-Komponenten, vorzugsweise von Titan und Chrom vorgesehen sein. Ebenso möglich ist ein von Einzellage zu Einzellage variierender Sauerstoffgehalt. Die Mäterial-Zusammensetzung der Einzellagen kann sich periodisch wiederholen. Sehr beständig wird die Verschleißschutzschicht 2 bei einem Multilagen-Aufbau, wenn die Gesamt-Schichtdicke mindestens 3 µm beträgt.

Ein Ausführungsbeispiel mit besonders guten Eigenschaften ist eine Verschleißschutzschicht 2 mit einer durchschnittlichen Material-Zusammensetzung von:

| Metallanteil (Σ 100 %) | | | | Nichtmetallanteil (Σ 100 %) | |
|---|---|---|---|---|---|
| A1 | Cr | Ti | Y | O | N |
| 72 % | 12 % | 15% | 1% | 5% | 95% |

Die Verschleißschutzschicht 2 dieses Beispiels besteht aus einem Multilagen-Aufbau, deren Einzellagen sukzessive in der Anlage 1 mittels des Sputter-Verfahrens abgeschieden worden sind. Die Einzellagen haben eine Lagendicke von etwa 4 bis 6 nm, wobei sich die Einzellagen in ihrer jeweiligen Material-Zusammensetzung voneinander unterscheiden. Die Material-Zusammensetzung der Einzellagen wiederholt sich periodisch mit einem Periodenabstand von zwei Einzellagen. So variiert im Metallanteil der Chrom-Anteil zwischen 6 und 21% und der Titan-Anteil zwischen 10 und 25 % sowie im Nichtmetallanteil der Sauerstoff-Anteil zwischen 1 und 8 %. Der Aluminium- und der Yttrium-Anteil bleiben dagegen im Wesentlichen konstant. Insofern sind die in der vorstehenden tabellarischen Zusammenstellung angegebenen Werte nur als über die gesamte Dicke aller Einzellagen gemittelte Durchschnittsangaben zu verstehen.

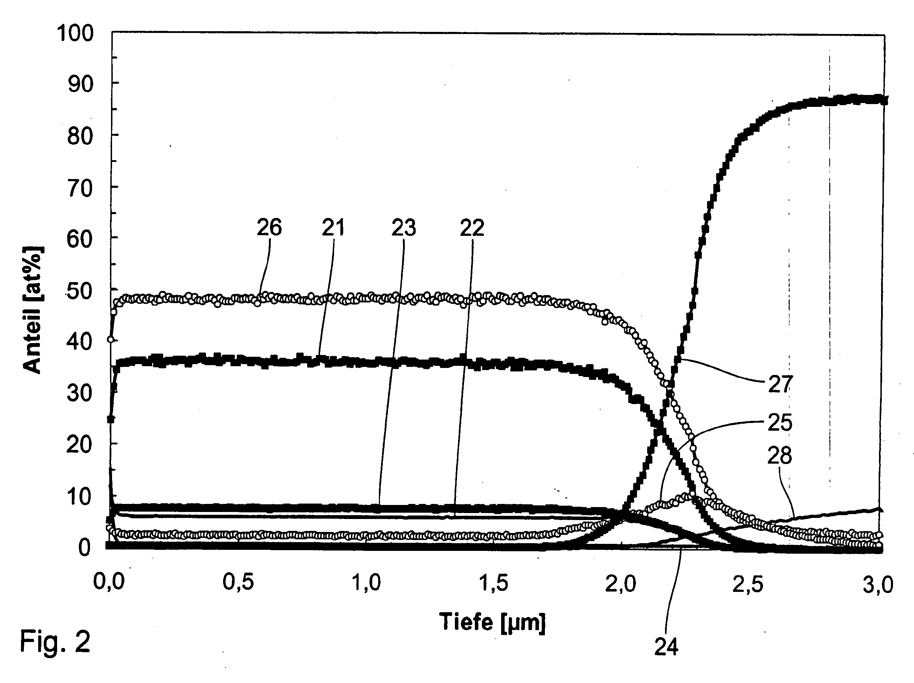

Dies gilt auch für die in Fig. 2 dargestellten gemessenen Tiefenprofile der verschiedenen Materialanteile der Verschleißschutzschicht 2. Die Einzellagen sind so dünn, dass sei mit der eingesetzten Analyse-Methode nicht mehr aufgelöst werden konnten. Die gemessenen Prozentangaben beziehen sich hierbei allerdings nicht wie bei der vorstehenden tabellarischen Zusammenstellung auf den Metallanteil oder den Nichtmetallanteil, sondern auf das gesamte Material. In einer Tiefe von etwa 1 µm lassen sich den Messkurven von Fig. 2 folgende durchschnittlichen Werte für die Material-Zusammensetzung entnehmen:

| Metallanteil (Σ ca. 49,7 %) | | | | Nichtmetallanteil (Σ ca. 50,3 %) | |
|---|---|---|---|---|---|
| Al | Cr | Ti | Y | O | N |
| 36,1 % | 5,7 % | 7,4 % | 0,5 % | 2,5 % | 47,5 % |

wobei mit 21 der Aluminium-Anteil, mit 22 der Chrom-Anteil, mit 23 der Titan-Anteil, mit 24 der Yttrium-Anteil, mit 25 der Sauerstoff-Anteil und mit 26 der Stickstoff-Anteil bezeichnet ist. Die Grenze zwischen der Verschleißschutzschicht 2 und dem Grundmaterial des beschichteten Werkzeugs 3 liegt bei etwa 2 µm. Tiefer im Material steigen die mit 27 und 28 bezeichneten Anteile von Eisen bzw. Kohlenstoff an und die für die Verschleißschutzschicht 2 unter anderem charakteristischen Stickstoff- und Aluminium-Anteile 26 bzw. 21 sinken ab.

Ein Vergleich der besonders günstigen Verschleißschutzschicht 2 aus Al-TiCrY(O,N), für die in Fig. 2 die Messwerte der Materialanteile aufgetragen sind, mit anderen bislang bekannten Verschleißschutzschichten verdeutlicht die erzielbare Verbesserung gerade hinsichtlich des besonders relevanten Standzeitverhaltens. Die Vergleichs-Verschleißschutzschichten bestehen aus Titannitrid (TiN), Titancarbonitrid (TiCN) und Titanaluminiumnitrid in verschiedener Material-Zusammensetzung (Ti(50)Al(50)N und Al(68)Ti(32)N).

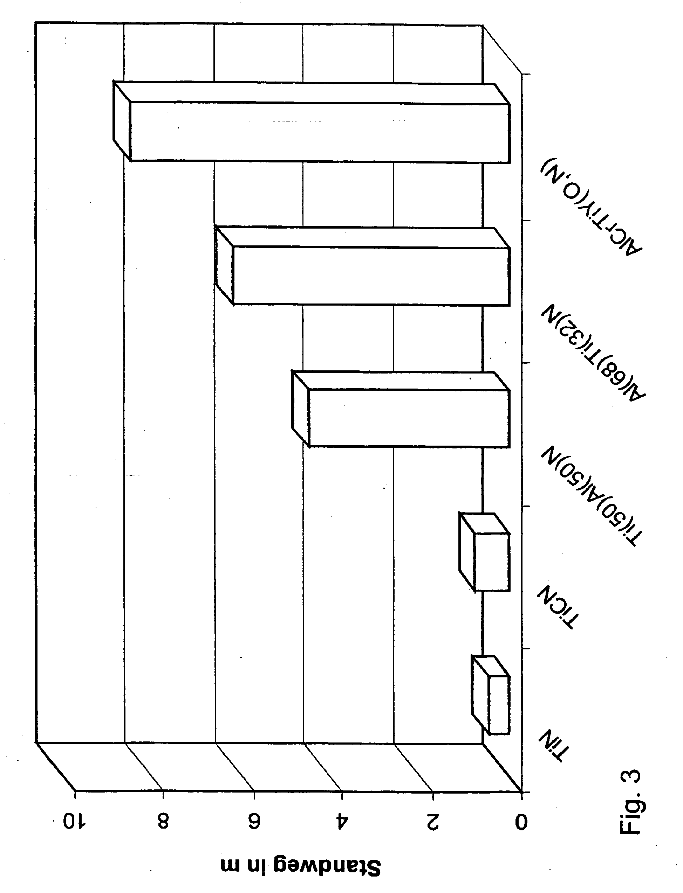

Der in Fig. 3 dokumentierte Vergleich ist mittels eines Trocken-Frästests mit folgenden Testbedingungen durchgeführt worden:

| | |
|---|---|
| Werkzeug: | Vollhartmetall-Radienfräser (Ø 8 mm) |
| Werkzeug-Spannung: | Hydrodehn |
| Auskraglänge l_{A}: | 26 mm |
| Kühlung / Schmierung: | trocken |
| Werkstück: | Werkzeugstahl 1.2379 mit Härte 62 HRC und gefräster Oberfläche |
| Werkstück-Spannung: | Maschinenschraubstock |
| Zustellung: | aₚ=5,0 mm (in Tiefenrichtung) |
| | aₑ=0,4 mm (in seitlicher Richtung) |
| Methode: | Abzeilen im Gleichlauf |
| Vorschubgeschwindigkeit V_{c}: | 100 m/min |
| Zustellgeschwindigkeit V_{f}: | 400 mm/min |

Die eingesetzten Vollhartmetall-Radienfräser wurden zuvor jeweils mit den zu vergleichenden Verschleißschutzschichten versehen. Erfasst und in Fig. 3 aufgetragen ist als Standweg in m diejenige Wegstrecke, die in dem Werkstück gefräst werden konnte, bis der jeweils eingesetzte beschichtete Fräser einen Verschleiß von mehr als 0,1 mm aufwies. Den Ergebnissen von Fig. 3 ist zu entnehmen, dass mittels der Verschleißschutzschicht 2 aus AlTiCrY(O,N) der längste Standweg zu erzielen ist. Sie weist folglich das mit Abstand beste Standzeitverhalten auf.

## Patentansprüche

1. Verschleißschutzschicht für ein formgebendes Werkzeug aus einem Material umfassend mindestens einen Metall-Materialanteil und einen Nichtmetall-Materialanteil, wobei
a) der Metall-Materialanteil die Metalle Aluminium, Chrom, Titan und Yttrium mit
- einem Chrom-Anteil (22) von 1 bis 60 %, vorzugsweise von 1 bis 40 %,
- einem Titan-Anteil (23) von 1 bis 29 %, vorzugsweise von 2 bis 25 %, und
- einem nicht-verschwindendem Yttrium-Anteil (24) von bis zu 5 %, vorzugsweise von 0,5 bis 4 %,
jeweils bezogen auf die gesamten Metall-Atomprozente im Material beinhaltet,
b) der Nichtmetall-Materialanteil die chemischen Elemente Stickstoff und Sauerstoff, insbesondere in Form eines Oxynitrids, mit
- einem auf die gesamten Nichtmetall-Atomprozente im Material bezogenen Sauerstoff-Anteil (25) von 1 bis 10 %, vorzugsweise von 1 bis 8 %
beinhaltet,
c) das Material als eine Multilagenbeschichtung aus mehreren Einzellagen vorliegt, und
d) die Einzellagen der Multilagenbeschichtung zumindest teilweise verschiedene Zusammensetzungen des Materials aufweisen, wobei ein Aluminium-Anteil (21) und der Yttrium-Anteil (24) konstant bleiben.

2. Verschleißschutzschicht nach Anspruch 1, **dadurch gekennzeichnet, dass** der Metall-Materialanteil einen Aluminium-Anteil (21) von 40 bis 85 %, vorzugsweise von 50 bis 80 %, bezogen auf die Metall-Atomprozente im Material beinhaltet.

3. Verschleißschutzschicht nach Anspruch 1 oder 2, **dadurch gekennzeichnet, dass** die Einzellagen Einzellagendicken zwischen 3 und 50 nm, vorzugsweise zwischen 3 und 20 nm, haben.

4. Verschleißschutzschicht nach Anspruch 1, **dadurch gekennzeichnet, dass** sich die Zusammensetzung des Materials der Einzellagen periodisch wiederholt.

5. Verschleißschutzschicht nach einem der vorhergehenden Ansprüche **gekennzeichnet durch** eine Gesamtdicke von etwa 0,5 bis 12 µm.

6. Verschleißschutzschicht nach Anspruch 1, **dadurch gekennzeichnet, dass** in den Einzellagen wechselnde Titan-Anteile (23) und Chrom-Anteile (22) vorgesehen sind.

7. Verschleißschutzschicht nach Anspruch 6, **dadurch gekennzeichnet, dass** zwischen den Einzellagen im Metall-Materialanteil der Chrom-Anteil (22) zwischen 6 und 21 % und der Titan-Anteil (23) zwischen 10 und 25 % variiert.

8. Verschleißschutzschicht nach Anspruch 1, **dadurch gekennzeichnet, dass** im Nichtmetall-Materialanteil der Sauerstoff-Anteil (25) von Einzellage zu Einzellage variiert.

9. Verschleißschutzschicht nach Anspruch 4, **dadurch gekennzeichnet, dass** sich die Material-Zusammensetzung der Einzellagen mit einem Periodenabstand von zwei Einzellagen wiederholt.

## Claims

1. Anti-abrasive coating for a forming tool of a material comprising at least one metal material content and one non-metal material content, wherein
a) the metal material content includes the metals aluminium, chromium, titanium and yttrium at
- a chromium content (22) of 1 to 60%, preferably of 1 to 40%;
- a titanium content (23) of 1 to 29%, preferably of 2 to 25%;
- a non-disappearing yttrium content (24) of up to 5%, preferably of 0.5 to 4%,
each of these contents being relative to the total percentage of metal atoms in the material;
b) the non-metal material content includes the chemical elements nitrogen and oxygen, in particular in the form of an oxynitride at
- an oxygen content (25) of 1 to 10%, in particular of 1 to 8%, relative to the total percentage of non-metal atoms in the material;
c) the material is provided as a multi-layer coating that is composed of several individual layers; and
d) the individual layers of the multi-layer coating have at least partially different compositions of material, wherein an aluminium content (21) and the yttrium content (24) remain constant.

2. Anti-abrasive coating according to claim 1, **characterized in that** the metal material content includes an aluminium content (21) of 40 to 85%, preferably 50 to 80%, relative to the percentage of metal atoms in the material.

3. Anti-abrasive coating according to claim 1 or 2, **characterized in that** the individual layers have individual layer thicknesses of between 3 and 50 nm, preferably between 3 and 20 nm.

4. Anti-abrasive coating according to claim 1, **characterized in that** the composition of the material of the individual layers repeats in a periodic manner.

5. Anti-abrasive coating according to one of the preceding claims, **characterized by** a total thickness of approximately 0.5 to 12 µm.

6. Anti-abrasive coating according to claim 1, **characterized in that** varying titanium contents (23) and chromium contents (22) are provided in the individual layers.

7. Anti-abrasive coating according to claim 6, **characterized in that** between the individual layers in the metal material content, the chromium content (22) varies between 6 and 21%, and the titanium content (23) varies between 10 to 25%.

8. Anti-abrasive coating according to claim 1, **characterized in that** in the non-metal material content, the oxygen content (25) varies from one individual layer to another.

9. Anti-abrasive coating according to claim 4, **characterized in that** the material composition of the individual layers repeats at a periodic distance of two individual layers.

## Revendications

1. Couche anti-abrasive pour un outil de mise en forme constitué d'un matériau comprenant au moins une partie en matériau métallique et une partie en matériau non métallique,
a) la partie en matériau métallique contenant les métaux aluminium, chrome, titane et yttrium avec
- un pourcentage de chrome (22) allant de 1 à 60 %, de préférence de 1 à 40 %,
- un pourcentage de titane (23) allant de 1 à 29 %, de préférence de 2 à 25 %, et
- un pourcentage d'yttrium non volatil (24) allant jusqu'à 5 %, de préférence allant de 0,5 à 4 %, par rapport à chaque fois au pourcentage total d'atomes métalliques dans le matériau,
b) la partie en matériau non métallique contenant les éléments chimiques d'azote et d'oxygène, en particulier sous la forme d'un oxynitrure, avec
- un pourcentage d'oxygène (25) allant de 1 à 10 %, de préférence de 1 à 8 % par rapport au pourcentage total d'atomes non métalliques dans le matériau,
c) le matériau étant présent sous la forme d'un dépôt de couches multiples composé de plusieurs couches individuelles, et
d) les couches individuelles du dépôt de couches multiples présentant au moins en partie différentes compositions de matériau, le pourcentage d'aluminium (21) et le pourcentage d'yttrium (24) restant constants.

2. Couche anti-abrasive selon la revendication 1, **caractérisée en ce que** le pourcentage de matériau métallique contient un pourcentage d'aluminium (21) allant de 40 à 85 %, de préférence allant de 50 à 80 %, par rapport au pourcentage d'atomes métalliques dans le matériau.

3. Couche anti-abrasive selon la revendication 1 ou 2, **caractérisée en ce que** les couches individuelles ont une épaisseur individuelle comprise entre 3 et 50 nm, de préférence comprise entre 3 et 20 nm.

4. Couche anti-abrasive selon la revendication 1, **caractérisée en ce que** la composition du matériau des couches individuelles se répète périodiquement.

5. Couche anti-abrasive selon l'une quelconque des revendications précédentes **caractérisée par** une épaisseur totale allant d'environ de 0,5 à 12 µm.

6. Couche anti-abrasive selon la revendication 1, **caractérisée en ce que** des pourcentages variables de titane (23) et de chrome (22) sont prévus dans les couches individuelles.

7. Couche anti-abrasive selon la revendication 6, **caractérisée en ce que** le pourcentage de chrome (22) varie de 6 à 21 % et le pourcentage de titane (23) de 10 à 25 % entre les couches individuelles dans la partie en matériau métallique.

8. Couche anti-abrasive selon la revendication 1, **caractérisée en ce que** le pourcentage d'oxygène (25) varie d'une couche individuelle à une autre couche individuelle dans la partie en matériau non métallique.

9. Couche anti-abrasive selon la revendication 4, **caractérisée en ce que** la composition du matériau dans les couches individuelles se répète avec un intervalle périodique de deux couches individuelles.
